# EUROPEAN PATENT SPECIFICATION

(11) **EP 0 637 080 B1**
(45) Date of publication and mention of the grant of the patent: **09.09.1998**
(21) Application number: 94305463.5
(22) Date of filing: 25.07.1994
(51) Int. Cl.: H01L 23/48, H01L 23/367

(54) **Pressure contact type semiconductor device**
Halbleiterbauelement mit Druckkontakt
Dispositif semi-conducteur du type de contact à pression

(30) Priority: 27.07.1993 JP 184271/93; 28.02.1994 JP 28623/94
(43) Date of publication of application: 01.02.1995
(60) Divisional application: 97104435.9
(73) Proprietor: FUJI ELECTRIC CO. LTD., Kawasaki 210 (JP)
(72) Inventor: Takahashi, Yoshikazu, Kawasaki-ku, Kawasaki 210 (JP)
(74) Representative: Bridge-Butler, Alan James

(56) References cited:
- EP-A- 0 428 916
- EP-A- 0 476 661
- EP-A- 0 499 707
- PATENT ABSTRACTS OF JAPAN vol. 16, no. 453 (E-1267) 21 September 1992 & JP-A-04 160 708 (NEC) 4 June 1992

## Description

The present invention relates to a pressure contact type semiconductor device, such as an insulated-gate bipolar transistor (IGBT) module, in which a plurality of semiconductor chips each having a first main electrode (emitter) and a control electrode (gate) on one principal surface of a substrate and a second main electrode (collector) on another principal surface.

The above-mentioned IGBT is widely applied as a power switching device to a motor PWM control inverter etc. With the increase of the size of semiconductor chips, the capacity of the IGBT has been further increased. Recently, to increase the capacity, a module structure in which a plurality of IGBTs are incorporated in a single package has been widely adopted.

In a MOS control device such as an IGBT, an emitter electrode as a main electrode and a gate electrode as a control electrode are formed side by side on one principal surface of a semiconductor chip. Because of this structure, when a device is assembled by packaging an IGBT chip, a collector on a second principal surface side can be directly mounted on a metal base that also serves as a heat radiator. but the emitter electrode and the gate electrode on the first principal surface side need to be connected to the exterior separately through external lead terminals. Therefore. in a conventional package assembly structure, in addition to the metal base, external lead terminals for the emitter and gate are provided on the top face of a package case. The connections between the emitter electrode and the external lead terminal, and between the gate electrode and the external electrode, are usually effected by wire bonding using an aluminium wire of about 300 *µ*m in diameter.

EP-A-0 499 707 describes a semiconductor device wherein a plurality of semiconductor chips each having a first main electrode and a control electrode on a first principal surface and a second main electrode on a second principal surface are incorporated in a flat package formed by interposing an insulating outer frame between a pair of common electrode plates with the joints sealed, and wherein contact terminal bodies are interposed between the first main electrodes of the respective semiconductor chips and the common electrode plate of the package opposed thereto, the control electrodes of the respective semiconductor chips are wire-connected to a control electrode wiring conductor that is provided on an inner periphery of the package, and an external lead terminal for the control electrodes is led outside of the package through the wiring conductor.

In the above conventional assembly structure, a large current capacity IGBT requires an increased number of bonding wires that are connected to the collector electrode. In particular, in a module structure incorporating a plurality of IGBTs in a single package, the number of wires reaches as many as several hundred. This increases the internal wiring inductance, which may cause a large voltage surge during a switching operation of the IGBT.

On the other hand, aiming at solving insufficient heat dissipation and large wiring inductance which are problems caused by the above assembly structure, it may be conceivable, as in the case of the conventional pressure contact type semiconductor devices, to incorporate an IGBT in a flat package, and arrange the emitter and collector electrodes that are formed on its respective principal surfaces in area contact with the respective top and bottom electrode plates of the package, to obtain electrical connection. However, since the IGBT is constructed such that the emitter electrode extends over an insulating layer that covers the gate electrode, if the package-side electrode is brought in pressure contact with the emitter electrode over the entire chip area, a pressure force is also exerted on the gate electrode to possibly destroy the gate electrode structure. Thus, the above pressure contact type structure in itself is not suitable for practical use.

EP-A-0499707 addresses the problem of wiring inductance, but requires the provision of closely toleranced contact pieces to fit between the semiconductor elements and an upper contact plate, either formed from the material of the contact plate or soldered thereto.

Further, where a pressure contact type flat package is adopted in a composite device in which an IGBT and an attached flywheel diode are incorporated together in a single package to constitute a composite device, the following problems arise: In general, the chip heights (wafer thicknesses) of the IGBT and the flywheel diode, which are dependent on their electrical characteristics, are different from each other. When these different types of semiconductor chips having different heights are incorporated in a single flat package so as to be placed adjacent to each other, there occurs a difference in the chip top face height, that is, the electrode surfaces of two adjacent semiconductor chips form a step that is opposed to the flat electrode plate which is to be brought in common plane contact with the respective semiconductor chips of the flat package if no proper countermeasure is introduced. This step makes it very difficult to attain uniform pressure contact. It is known from experiments etc. that in this case if the difference between the heights of the semiconductor chips is not made within ±50*µ*m, the heat dissipation performance and the electrical characteristics of the semiconductor device are much reduced.

More specifically, while conventional IGBTs generally use a wafer (called "epitaxial wafer") that is formed by sequentially growing n⁺ and n⁻ layers on a p⁺ silicon substrate by epitaxy to attain desired switching characteristics, flywheel diodes use a wafer that is formed by growing an n⁺ layer by epitaxy on an n⁻ silicon substrate that is produced by the FZ or MCZ method to produce the wafer at a lower cost. In these epitaxial wafers and FZ or MCZ wafers, the thickness of the n⁻ layer is set at such an optimum value as provides the desired operating characteristics.

In the epitaxial wafer employed in the IGBT, a highly doped substrate is employed as the p⁺ silicon substrate to make its resistance so small as to be irrelevant to the saturation voltage, and the thickness of the p⁺ substrate is so set as to secure the necessary mechanical strength. On the other hand, in the diode using the FZ or MCZ wafer, the n⁺ epitaxial layer formed on the n⁻ silicon substrate is thin and, therefore, the total thickness of the substrate is substantially solely determined by the thickness of the n⁻ layer. As a result, in general, the IGBT chip has a greater wafer thickness and thus larger height than the flywheel diode chip, and the chip heights are not equal to each other when they are placed adjacent to each other on a flat electrode plate for assembling. That is, a level difference occurs between the top faces of the chips.

The present invention has been made in view of the above circumstances. With respect to a composite device in which IGBTs and flywheel diodes are incorporated together in a single flat package, an objective of the invention is to provide a pressure contact type semiconductor device which enables uniform pressure contact between the semiconductor chips and a common electrode plate of the package by equalizing thicknesses and parallelisms of the respective semiconductor chips without reducing their operating performance characteristics.

In accordance with the invention, there is provided a pressure contact type semiconductor device in which a plurality of insulated-gate bipolar transistor chips each having a first main electrode and a control electrode on a first principal surface and a second main electrode on a second principal surface are incorporated in a flat package so as to be placed adjacent to each other, and said semiconductor device further includes at least one flywheel diode chip having a first main electrode on a first principal surface and a second main electrode on a second principal surface, the flywheel diode chip and the IGBT chips being of a bonded wafer construction formed by bonding a highly doped silicon substrate on the side of the second principal surface so that the resulting semiconductor chips have the same height and being incorporated into the same flat package with the diode chip placed adjacent to the plurality of insulated-gate bipolar transistor chips, wherein the flat package comprises an insulating outer frame interposed between and sealingly attached to the opposing faces of a pair of common electrode plates, contact terminal bodies serving both as pressure members and as heat radiators being interposed between the first main electrodes of the respective diode and IGBT chips and the common electrode plate of the package opposed thereto, the control electrodes of the respective diode and IGBT chips being wire-connected to a control electrode wiring conductor that is provided on an inner periphery of the package, and an external lead terminal for the control electrodes is led from outside of the package through to the wiring conductor, characterised in that a positioning member for holding the contact terminal bodies that are in contact with the first main electrodes of the respective diode and IGBT chips in place is incorporated in the flat package, and wherein at least one cutting recess for avoiding contact with a connection wire leading from the control electrode of the IGBT chip is formed in a peripheral portion of each contact terminal body, and wherein the periphery of the positioning member contacts with the inner wall of the insulating outer frame of the package, and the positioning member has windows at positions corresponding to the positions of the IGBT and the flywheel diode chips, the contact terminal bodies fitting in the windows.

The above pressure contact type semiconductor device may be assembled in specific forms described below.
(1) A positioning member for holding in place the contact terminal bodies that are in contact with the first main electrodes of the respective semiconductor chips is incorporated in the flat package, and the respective contact terminal bodies are held in place in the package by use of the interposing positioning member.
(2) At least one cutting recess for avoiding contact with a connection wire leading from the control electrode of the semiconductor chip is formed in a peripheral portion of the contact terminal body.
(3) The control electrode wiring conductor is formed on an inner wall of the insulating outer frame of the flat package so as to surround the semiconductor chips, and the external lead terminal connected to the control electrode wiring conductor is led out of the package, penetrating through the insulating outer frame.
(4) A bonded wafer formed by bonding a highly doped silicon substrate on the side of the second principal surface is adopted in each of the insulated-gate bipolar transistors and the flywheel diode so that the semiconductor chips have substantially the same height.

In the above constitution, for each of the plurality of semiconductor chips incorporated in the flat package, the main electrode is brought in pressure contact with the contact terminal body that is interposed between the first principal surface side and the common electrode of the package opposed thereto so as to avoid interference with the control electrode, and that is in area contact with the main electrode. Thus, heat dissipation to the exterior can also be effected on the first principal surface side through the contact terminal body, without exerting undue mechanical pressure on the control electrode structure of the semiconductor chip. Combined with the heat dissipation on the second principal surface side, the heat dissipation performance is greatly improved and an increase of the current capacity of the semiconductor device is obtainable. Further, since the main electrodes of the semiconductor chips are directly connected to the terminal bodies by area contact without using bonding wires, the internal wiring inductance is reduced as compared with the case of bonding wire connections. Since the control electrodes are wire-connected to the wiring conductor that is provided on the inner periphery of the package so as to surround the semiconductor chips, connection to the control electrodes can be effected laterally without causing interference with the contact terminal bodies that are in pressure contact with the main electrodes.

On the other hand, if the bonded wafers are adopted in the plurality of IGBTs and the flywheel diodes in constituting a pressure contact type composite device (IGBT module) by incorporating the IGBTs and the tlywheel diodes in the flat package, and if the thicknesses of the bonded wafers are properly adjusted, the heights of all the semiconductor chips can be equalized without detriment to their electrical characteristics. By incorporating the IGBTs and the flywheel diodes having the same height in the flat package, the top faces of the IGBTs and the flywheel diodes are in the same plane, whereby uniform pressure contact can be obtained between the IGBTs and flywheel diodes and the common electrode plate of the package through the contact terminal bodies of the same thickness.

When the IGBTs and the flywheel diodes are incorporated in the single package so as to be adjacent to each other, preferably thermoplastic conductive sheets such as solder sheets are interposed between the second principal surfaces of the respective semiconductor chips and the electrode plate opposed thereto, and in this temporarily assembled state the conductive sheets are heated and a pressing operation is effected on all the chips from the side of the first principal surfaces. As a result, the conductive sheets are plastically deformed so as to accommodate any differences in height between the IGBTs and the flywheel diodes and variations in height among the respective chips to thereby allow the top faces of the respective semiconductor chips to lie in a parallel coplanar array and thus effectively equalise the heights of those faces. Uniform pressure contact between the common electrode plate of the flat package and the respective semiconductor chips incorporated in the package is thereby achieved.

An embodiment of the present invention will be hereinafter described with reference to the accompanying drawings, in which:

Figure 1 is a sectional view showing an assembly structure of a pressure contact type semiconductor device according to an embodiment of the present invention.

Figure 2 is a plan view showing an arrangement of parts incorporated in a flat package in Figure 1.

Figures 3a and 3b show the structure of a contact terminal body in Figure 1; Figure 3a is a bottom view and Figure 3b is a side view.

Figures 4a and 4b show a bonded wafer employed in IGBTs in Figure 1; Figure 4a shows a state before bonding and Figure 4b shows a state after the bonding.

Figures 5a and 5b show a bonded wafer employed in a flywheel diode in Figure 1; Figure 5a shows a state before bonding and Figure 5b shows a state after the bonding.

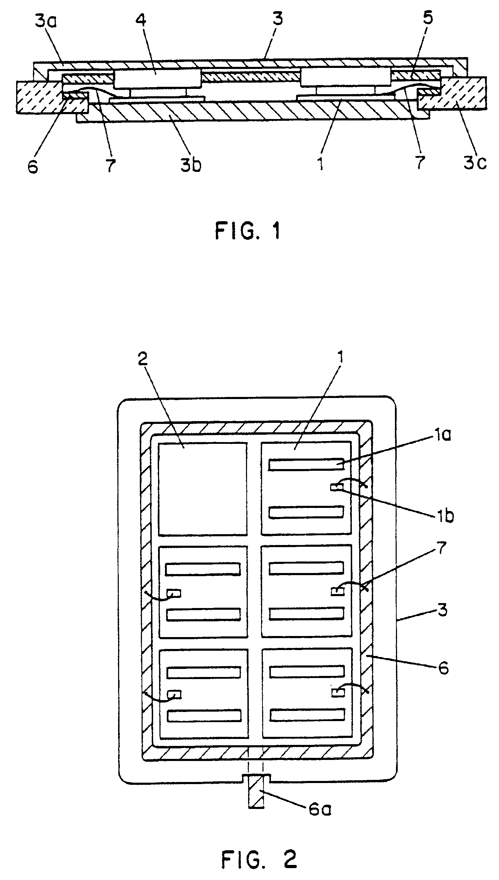

Referring now to the drawings, Figures 1 and 2 show a pressure contact type IGBT module in which five IGBTs and one flywheel diode are placed adjacent to each other in a substantially coplanar array within a flat package. In the embodiment seen in Figures 1 and 2, an array of six chips is arranged in two rows of three, one row comprising three IGBTs 1, and the other row comprising two IGBTs 1 and a flywheel diode 2. A pressure contact type flat package 3 encloses the IGBTs 1 and the flywheel diode 2.

A silicon substrate of each IGBT 1 has a size of about 20 mm x 20 mm. The bottom principal face of the IGBT 1 (the underside as seen in Figure 1) is made the collector, and two strip-like emitter electrodes 1a each having a width of about 2 mm and a length of about 16 mm are formed on the upper principal face (as seen in Figure 1) so as to avoid a gate structure with a gate electrode 1b formed between the emitter electrodes 1a. The flywheel diode 2 is placed adjacent to the IGBTs 1 in the flat package 3 such that the top face and the bottom face of the silicon substrate are made the anode and cathode, respectively.

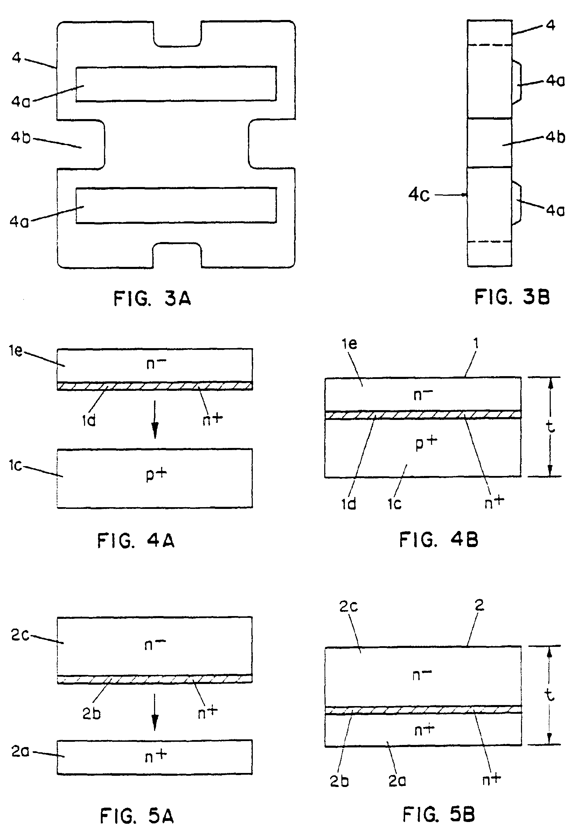

As shown in Figures 4 and 5, the silicon substrates of the IGBT 1 and the flywheel diode 2 are produced from bonding wafer types so that the total thicknesses of those substrates are equalized. More specifically, as shown in Figures 4a and 4b, the silicon substrate of the IGBT 1 is formed such that an n⁻ wafer le having an epitaxially grown n⁺ layer 1d is bonded to a p⁺ wafer (highly doped silicon substrate) 1c as a base. The total thickness of the substrate is t. On the other hand, as shown in Figures 5a and 5b. the silicon substrate of the flywheel diode 2 is formed such that an n⁻ wafer 2c having an epitaxially grown n⁺ layer 2b is bonded to an n⁺ wafer (highly doped silicon substrate) 2a. The thickness of the n⁺ wafer 2a is adjusted so that the total thickness becomes equal to that of the silicon substrate of the IGBT 1, i.e., t.

On the other hand, the aforementioned flat package 3 consists of a pair of common electrode plates 3a and 3b respectively exposed to the top and bottom face sides and opposed to the emitters and collectors of the IGBTs 1, and a ceramic insulating outer frame 3c interposed between the peripheries of the common electrode plates 3a and 3b so as sealingly to join the edge regions of those plates. That is, a hermetically sealed package is constituted of the above parts. After the IGBTs 1 and the flywheel diode 2 are mounted, with an arrangement as shown in Figure 2, on the common electrode plate 3b which forms the bottom of the package (as seen in Figure 1), a respective contact terminal body 4, serving both as a heat radiator and as a pressure member, is interposed between the emitter electrodes 1a of each IGBT 1 and the top-face-side main electrode of the flywheel electrode 2 and common electrode plate 3a forming the upper face of the package 3.

The contact terminal body 4, as seen in Figure 3, is a rectangular plate made of a material, such as molybdenum, having superior thermal and electrical conductivity. While its top face 4c is finished into a flat surface to contact the electrode plate 3a, the opposite face, intended to contact the IGBT 1, has two protruding strips 4a that are to make area contact with the emitter electrodes 1a of the IGBT 1. Further, recessed cutouts 4b are formed in peripheral portions of the contact terminal body 4 to avoid contact with a wire leading from a gate electrode 1b of the IGBT 1, which will be described later. The external dimensions of the contact terminal bodies 4 are determined in accordance with the chip sizes of the IGBTs 1 and the flywheel diode 2, and their thicknesses are the same. As shown in Figure 1, the contact terminal bodies 4 are held in place in the package by use of an interposing positioning plate 5 made of heat-resisting resin or rubber. The positioning plate 5 is fitted in the flat package 3 such that its periphery contacts with the inner wall of the insulating outer frame 3c of the package 3, and has windows at positions corresponding to the positions of the IGBTs 1 and the flywheel diode 2 so that the contact terminal bodies 4 can be fitted in the windows. It is preferred that tongues to engage with the cutouts 4b (see Figure 3) be formed so as to project into each window, to ensure the correct rotational positioning of the terminal bodies 4.

A gate wiring conductor 6 (hatched in the Figures) is evaporated onto the top face of a step (wiring base) that is formed in the inner wall of the insulating outer frame 3c of the flat package 3, to extend over the entire circumference of the frame 3c. The gate electrodes 1b of the respective IGBTs 1 are connected to the gate wiring conductor 6 by gate wire leads 7 bonded thereto. The gate wire leads 7 do not contact the contact terminal bodies 4 because the gate wire leads 7 are led out through the cutouts 4b of the terminal bodies 4 (see Figure 3). The gate wiring conductor 6 is connected to a gate external lead terminal 6a that penetrates through the insulating outer frame 3c to be led outside the package 3.

In the above assembly, since the IGBTs 1 and the flywheel diode 2 incorporated in the flat package 3 are arranged so as to have the same thickness, uniform pressure contact can be obtained between the IGBTs 1 and the flywheel diode 2 and the common electrode plate 3a of the flat package through the contact terminal bodies 4. Heat that is generated by current conduction in the silicon substrate of the IGBT 1 is dissipated to the outside not only through the common electrode plate 3a of the package 3 on the collector side, but also through the contact terminal bodies 4 and the upper common electrode plate 3a on the emitter side. Therefore, compared to the conventional bonding wire type package structure, the heat dissipation efficiency is greatly improved and the current capacity can be approximately doubled. In addition, since no bonding wire is used to make electrical connection to the emitter, the internal wiring inductance is reduced to thereby suppress a voltage surge to a lower level which occurs in association with a switching operation.

By employing the arrangement of claims 1 to 4, the invention provides the following advantages that a plurality of semiconductor chips can be incorporated in the flat package without exerting undue pressure on the control electrode structures of the semiconductor chips, to provide uniform pressure contact by plane contact. Heat dissipation to the exterior can be effected through the electrodes formed on both of the first and second principal surfaces of each semiconductor chip. As a result, the heat dissipation performance can be greatly improved to thereby much increase the current capacity of the semiconductor device. Since no bonding wires are used for the connection to the main electrodes, the internal wiring inductance is reduced, which, combined with the flat package of the hermetic seal structure, improves the reliability of the semiconductor device.

## Claims

1. A pressure contact type semiconductor device in which a plurality of insulated-gate bipolar transistor -IGBT- chips (1) each having a first main electrode (1a) and a control electrode (1b) on a first principal surface and a second main electrode on a second principal surface are incorporated in a flat package (3) so as to be placed adjacent to each other, and said semiconductor device further includes at least one flywheel diode chip (2) having a first main electrode on a first principal surface and a second main electrode on a second principal surface, the flywheel diode chip (2) and the IGBT chips (1) being of a bonded wafer construction formed by bonding a highly doped silicon substrate on the side of the second principal surface so that the diode and IGBT chips (1, 2) have the same height and being incorporated into the same flat package (3) with the diode chip (2) placed adjacent to the plurality of IGBT chips (1), wherein the flat package comprises an insulating outer frame (3c) interposed between and sealingly attached to the opposing faces of a pair of common electrode plates (3a, 3b), contact terminal bodies (4) serving both as pressure members and as heat radiators being interposed between the first main electrodes (1a) of the respective diode and IGBT chips (1, 2) and the common electrode plate (3a) of the package opposed thereto, the control electrodes (1b) of the respective IGBT chips (1) being wire-connected to a control electrode wiring conductor (6) that is provided on an inner periphery of the package, and an external lead terminal (6a) for the control electrodes is led from outside of the package through to the wiring conductor, characterised in that a positioning member (5) for holding the contact terminal bodies (4) that are in contact with the first main electrodes (1a) of the respective diode and IGBT chips (1, 2) in place is incorporated in the flat package, and wherein at least one cutting recess (4b) for avoiding contact with a connection wire (7) leading from the control electrode (1b) of the IGBT chip (1) is formed in a peripheral portion of each contact terminal body (4), and wherein the periphery of the positioning member (5) contacts with the inner wall of the insulating outer frame (3c) of the package (3), and the positioning member (5) has windows at positions corresponding to the positions of the diode and IGBT chips (1, 2), the contact terminal bodies (4) fitting in the windows.

2. A pressure contact type semiconductor device according to claim 1, characterised in that the control electrode wiring conductor (6) is formed on an inner wall of the insulating outer frame (3c) of the flat package (3) so as to surround the diode and IGBT chips (1, 2), and the external lead terminal (6a) which is connected at one end to the control electrode wiring conductor (6) is led to the outside of the package (3) by penetrating through the insulating outer frame (3c).

3. A pressure contact type semiconductor device according to claim 1, characterised in that the top faces (4c) of the contact terminal bodies (4) are flat surfaces contacting the electrode plate (3a), while the opposite faces of the contact terminal bodies (4) contacting the respective IGBT chips (1) have two protruding strips (4a) to make area contact with the emitter electrodes (1a) of the IGBT chips (1).

4. A pressure contact type semiconductor device according to any one of claims 1 to 3, characterised in that the second principal surfaces of the respective diode and IGBT chips (1, 2) and the electrode plate (3b) opposed thereto are bonded to each other through thermoplastic conductive sheets such as solder sheets interposed therebetween.

## Patentansprüche

1. Halbleiterbauelement mit Druckkontakt, bei dem mehrere Chips (1) mit Bipolartransistoren mit isolierten Gateelektroden (IGBT) und mit jeweils einer ersten Hauptelektrode (1a) und einer Steuerelektrode (1b) auf einer ersten Hauptfläche und mit einer zweiten Hauptelektrode auf einer zweiten Hauptfläche in einem Flachgehäuse (3) so untergebracht sind, daß sie nebeneinanderliegen, und das Halbleiterbauelement des weiteren zumindest einen Flywheel-Dioden-Chip (2) mit einer ersten Hauptelektrode auf einer ersten Hauptfläche und einer zweiten Hauptelektrode auf einer zweiten Hauptfläche enthält, wobei der Flywheel-Dioden-Chip (2) und die IGBT-Chips (1) eine gebondete Wafer-Bauweise besitzen, die dadurch entsteht, daß ein hochdotiertes Siliciumsubstrat so auf die Seite der zweiten Hauptfläche gebondet ist, daß der Dioden-Chip und die IGBT-Chips (1, 2) die gleiche Höhe aufweisen, und im selben Flachgehäuse (3) so untergebracht sind, daß der Dioden-Chip (2) neben den IGBT-Chips (1) angeordnet ist, wobei das Flachgehäuse einen äußeren Isolierrahmen (3c), der zwischen den gegenüberliegenden Seiten zweier Platten der gemeinsamen Elektroden (3a, 3b) angeordnet und bei gleichzeitiger Abdichtung damit verbunden ist, und als Druckelemente und Wärmestrahler dienende Kontaktanschlußkörper (4) zwischen den ersten Hauptelektroden (1a) des entsprechenden Dioden-Chips und der entsprechenden IGBT-Chips (1, 2) und der gegenüberliegenden Platte der gemeinsamen Elektrode (3a) des Gehäuses umfaßt, wobei die Steuerelektroden (1b) der entsprechenden IGBT-Chips (1) über einen Draht mit einer am inneren Umfang des Gehäuses vorgesehenen Steuerelektrodenvedrahtungsleiterbahn (6) verbunden sind, und ein äußerer Zuleitungsanschluß (6a) für die Steuerelektroden von der Außenseite durch das Gehäuse an die Verdrahtungsleiterbahn geführt ist, dadurch gekennzeichnet, daß ein Positionierungselement (5) zum Festhalten der mit den ersten Hauptelektroden (1a) des entsprechenden Dioden-Chips und der entsprechenden IGBT-Chips (1, 2) in Kontakt stehenden Kontaktanschlußkörper (4) in dem Flachgehäuse angeordnet ist und wobei zumindest eine Aussparung (4b) am Umfang jedes Kontaktanschlußkörpers (4) vorhanden ist, um eine Berührung mit einem von der Steuerelektrode (1b) des IGBT-Chips (1) kommenden Verbindungsdraht (7) zu vermeiden, und wobei der Umfang des Positionierungselements (5) mit der Innenwand des äußeren Isolierrahmens (3c) des Gehäuses (3) in Kontakt steht und das Positionierungselement (5) an den dem Dioden-Chip und den IGBT-Chips (1, 2) entsprechenden Positionen Fenster besitzt, und wobei die Kontaktanschlußkörper (4) in die Fenster passen.

2. Halbleiterbauelement mit Druckkontakt nach Anspruch 1, dadurch gekennzeichnet, daß die Steuerelektrodenverdrahtungsleiterbahn (6) an der Innenwand des äußeren Isolierrahmens (3c) des Flachgehäuses (3) so geformt ist, daß sie den Dioden-Chip und die IGBT-Chips (1) umgibt, und der an einem Ende mit der Steuerelektrodenverdrahtungsleiterbahn (6) verbundene äußere Zuleitungsanschluß (6a) durch den äußeren Isolierrahmen (3c) aus dem Gehäuse (3) herausführt.

3. Halbleiterbauelement mit Druckkontakt nach Anspruch 1, dadurch gekennzeichnet, daß die Oberseiten (4c) der Kontaktanschlußkörper (4) ebene, mit der Elektrodenplatte (3a) in Kontakt stehende Flächen sind, während die gegenüberliegenden Seiten der mit den entsprechenden IGBT-Chips (1) in Kontakt stehenden Kontaktanschlußkörper (4) zwei vorstehende Streifen (4a) besitzt, so daß ein Flächenkontakt mit den Emitterelektroden (1a) der IGBT-Chips (1) entsteht.

4. Halbleiterbauelement mit Druckkontakt nach einem der Ansprüche 1 bis 3, dadurch gekennzeichnet, daß die zweiten Hauptflächen des entsprechenden Dioden-Chips und der entsprechenden IGBT-Chips (1, 2) und die gegenüberliegende Elektrodenplatte (3b) über dazwischen angeordnete leiffähige Thermoplastfolien, wie beispielsweise Lötfolien, miteinander gebondet sind.

## Revendications

1. Dispositif semi-conducteur du type de contact par pression dans lequel plusieurs puces (1) à transistors bipolaires à grille isolée - IGBT - ayant chacune une première électrode principale (1a) et une électrode de commande (1b) sur une première surface principale et une seconde électrode principale sur une seconde surface principale sont incorporées dans un boîtier plan (3) de façon à être disposées au voisinage les unes des autres, et ledit dispositif semi-conducteur comprend en outre au moins une puce (2) à diode volante comportant une première électrode principale sur une première surface principale et une seconde électrode principale sur une seconde surface principale, la puce (2) à diode volante et les puces IGBT (1) étant d'une construction en tranches liées formées en liant un substrat en silicium hautement dopé sur le côté de la seconde surface principale de sorte que les puces (1, 2) IGBT et à diode ont la même hauteur et sont incorporées à l'intérieur du même boîtier plan (3), la puce (2) à diode étant disposée au voisinage de la pluralité de puces IGBT (1), dans lequel le boîtier plan comprend un cadre (3c) extérieur isolant intercalé entre les faces opposées de deux plaques d'électrode communes (3a, 3b) et fixé hermétiquement à celles-ci, des corps (4) de bornes de contact servant à la fois d'éléments de pression et dissipateurs thermiques étant intercalés entre les premières électrodes principales (1a) des puces (1, 2) IGBT et à diode respectives et la plaque d'électrode commune (3a) du boîtier opposée à celles-ci, les électrodes de commande (1b) des puces IGBT (1) respectives étant reliées par fil électrique à un conducteur (6) de câblage d'électrode de commande qui est prévu sur une périphérie intérieure du boîtier, et une borne (6a) de sortie extérieure prévue pour les électrodes de commande est amenée depuis l'extérieur à travers le boîtier vers le conducteur de câblage, caractérisé en ce qu'un élément de positionnement (5) destiné à maintenir en place les corps (4) de borne de contact qui sont en contact avec les premières électrodes principales (1a) des puces (1, 2) IGBT et à diode respectives est incorporé dans le boîtier plan, et dans lequel au moins un évidement découpé (4b) destiné à éviter tout contact avec un fil de connexion (7) partant de l'électrode de commande (1b) de la puce IGBT (1) est formé dans une partie périphérique de chaque corps (4) de borne de contact, et dans lequel la périphérie de l'élément de positionnement (5) est en contact avec la paroi intérieure du cadre (3c) extérieur isolant du boîtier (3), et l'élément de positionnement (5) comporte des ouvertures à des positions correspondant aux positions des puces (1, 2) IGBT et à diode, les corps (4) de borne de contact s'emboîtant dans les ouvertures.

2. Dispositif semi-conducteur du type de contact par pression selon la revendication 1, caractérisé en ce que le conducteur (6) de câblage d'électrode de commande est formé sur une paroi intérieure du cadre (3c) extérieur isolant du boîtier plan (3) de façon à entourer les puces (1, 2) IGBT et à diode, et la borne (6a) de sortie extérieure qui est reliée à une extrémité au conducteur (6) de câblage d'électrode de commande mène à l'extérieur du boîtier (3) en pénétrant à travers le cadre (3c) extérieur isolant.

3. Dispositif semi-conducteur du type de contact par pression selon la revendication 1, caractérisé en ce que les faces supérieures (4c) des corps (4) de borne de contact sont des surfaces planes qui sont en contact avec la plaque d'électrode (3a), tandis que les faces opposées des corps (4) de borne de contact sont en contact avec les puces IGBT (1) respectives, comportent deux bandes saillantes (4a) destinées à réaliser un contact de surface avec les électrodes (1a) d'émetteurs des puces IGBT (1).

4. Dispositif semi-conducteur du type de contact par pression selon l'une quelconque des revendications 1 à 3, caractérisé en ce que les secondes surfaces principales des puces (1, 2) IGBT et à diode respectives et la plaque d'électrode (3b) opposée à celles-ci sont liées les unes aux autres par l'intermédiaire de feuilles conductrices thermoplastiques telles que des feuilles de brasure intercalées entre elles.
